**Europäisches Patentamt**

(19) **European Patent Office**

**Office européen des brevets**

(11) Publication number : **0 397 943 B1**

# EUROPEAN PATENT SPECIFICATION

(45) Date of publication of patent specification :
07.12.94 Bulletin 94/49

(51) Int. Cl.[5] : **H01L 39/24, H01L 39/14**

(21) Application number : **89305080.7**

(22) Date of filing : **19.05.89**

(54) **Method of producing a superconductive oxide cable and wire.**

(43) Date of publication of application :
22.11.90 Bulletin 90/47

(45) Publication of the grant of the patent :
07.12.94 Bulletin 94/49

(84) Designated Contracting States :
CH DE FR GB LI NL

(56) References cited :
JAPANESE JOURNAL OF APPLIED PHYSICS,
vol. 27, no. 2, February 1988, pp. L185-L187,
Tokyo, JP; M. OKADA et al.: "Fabrication of
Ag-sheated Ba-Y-Cu oxide superconductor
tape"
APPLIED PHYSICS LETTERS, vol. 54, no. 16,
17th April 1989, pp. 1582-1584, American Insti-
tute of Physics, New York, US; M. MIMURA et
al.: "Improvement of the critical current den-
sity in the silver sheathed Bi-Pb-Sr-Ca-Cu-O
superconducting tape"
ADVANCES IN CRYOGENIC ENGINEERING:
MATERIALS, vol. 34, 1988, pp. 617-623, New
York, US; K. TOGANO et al.: "High tempera-
ture superconductivity in the Ba-Y-Cu oxide
system"

(73) Proprietor : FUJIKURA LTD.
No. 5-1 Kiba 1-chome
Kohtoh-ku Tokyo (JP)

(72) Inventor : Ikeno, Yoshimitsu
Fujikura Limited., 5-1, Kiba 1-chome
Kohtoh-ku Tokyo (JP)
Inventor : Kohno, Osamu
Fujikura Limited., 5-1, Kiba 1-chome
Kohtoh-ku Tokyo (JP)
Inventor : Goto, Kenji
Fujikura Limited., 5-1, Kiba 1-chome
Kohtoh-ku Tokyo (JP)

Inventor : Kume, Atsushi
Fujikura Limited., 5-1, Kiba 1-chome
Kohtoh-ku Tokyo (JP)
Inventor : Aoki, Shin'ya
Fujikura Limited., 5-1, Kiba 1-chome
Kohtoh-ku Tokyo (JP)
Inventor : Sadakata, Nobuyuki
Fujikura Limited., 5-1, Kiba 1-chome
Kohtoh-ku Tokyo (JP)
Inventor : Sugimoto, Masaru
Fujikura Limited., 5-1, Kiba 1-chome
Kohtoh-ku Tokyo (JP)
Inventor : Usui, Toshio
Fujikura Limited., 5-1, Kiba 1-chome
Kohtoh-ku Tokyo (JP)
Inventor : Nakagawa, Mikio
Fujikura Limited., 5-1, Kiba 1-chome
Kohtoh-ku Tokyo (JP)
Inventor : Yamaguchi, Taichi
Fujikura Limited., 5-1, Kiba 1-chome
Kohtoh-ku Tokyo (JP)
Inventor : Hasegawa, Masagazu
Fujikura Limited., 5-1, Kiba 1-chome
Kohtoh-ku Tokyo (JP)
Inventor : Okiai, Ryuichi
Fujikura Limited., 5-1, Kiba 1-chome
Kohtoh-ku Tokyo (JP)
Inventor : Yoshida, Syotaro
Fujikura Limited., 5-1, Kiba 1-chome
Kohtoh-ku Tokyo (JP)
Inventor : Tan, Masayuki
Fujikura Limited., 5-1, Kiba 1-chome
Kohtoh-ku Tokyo (JP)
Inventor : Yamanouchi, Hiroshi
Fujikura Limited., 5-1, Kiba 1-chome
Kohtoh-ku Tokyo (JP)
Inventor : Ohnishi, Akifumi
Fujikura Limited., 5-1, Kiba 1-chome
Kohtoh-ku Tokyo (JP)

(74) Representative : Calderbank, Thomas Roger et
al
MEWBURN ELLIS
York House
23 Kingsway
London WC2B 6HP (GB)

## Description

Background of the Invention

Intense efforts in research and development are directed toward superconductive oxides for practical use, for example, magnet coils of the nuclear magnetic resonance imaging apparatus, magnet coils of the particle accelerator, the power transmission line and a like use. The present invention relates to a method of producing an oxide superconductor, which exhibits excellent superconductivity and high mechanical strength as compared to the superconductor produced by the prior art method, and an oxide superconductor produced by the method.

Recently, various superconductive oxides with high critical temperatures (Tc) have been discovered. For producing superconducting wires including such superconductive oxides, for example, Y-Ba-Cu oxide, there has been proposed that a powder mixture which includes $Y_2O_3$ powder, BaO powder and CuO powder is charged into a metallic pipe, which is then diameter reduced to form a composite wire, which is in turn heat treated for a solid-state reaction so that the superconductive oxide is produced in the core. According to such a method, it is difficult to provide a high forging ratio without breaking of the composite wire. Thus, the core, having an insufficient green density, of the composite wire has a tendency that during heat treatment thereof, solid phase reaction does not take place sufficiently and hence excellent superconductivity is not obtained. Further, when sintered, a core of such an insufficient green density provides a relatlively large porosity of superconductor, which is poor in mechanical strength and is liable to produce cracks in it when it is wound around a magnet core, the cracks considerably degrading superconductivity thereof.

In some occasions, it is desirable to make superconductive materials in a tape or membrane form. But, according to prior technologies, manufacturing method of such materials is limited to the methods wherein a superconductive layer is formed on a tape-formed or membrane-formed base material by means of plasma radiation, spattering, etc. But those are not efficient and not economic. Furthermore, superconductive materials obtained by those methods do not have sufficient superconductivity.

A paper in the Japanese Journal of Applied Physics, Volume 27, Number 2 (February 1988), pages L185-L187, entitled "Fabrication of Ag-Sheathed Ba-Y-Cu Oxide Superconductor Tape" describes a method for fabricating a superconductor tape of the $Ba_2$-Y-$Cu_3$-$O_{7-d}$ type. The fabrication process involves forming a filling material, charging the filling material into a metallic (Ag) pipe to form a preform, cold rolling the preform into a tape and subsequently heat treating the tape.

A paper entitled "Improvement of the Critical Current Density in the Silver Sheathed Bi-Pb-Sr-Ca-Cu-O Superconducting Tape", published in Applied Physics Letters, Volume 54, Number 16 (April 1989), pages 1582 and 1583, describes a process for making a silver sheathed superconducting tape of the Bi-Pb-Sr-Ca-Cu-O type. This process includes the cold swaging of silver tubes packed with the superconducting powder, to form wires which are then rolled to tapes of a desired thickness. The swaging step is not described as yielding any particular density of the resultant wires.

It is an object of the present invention to provide a method of producing a superconductor, in which the green density of the compact is raised fairly high as compared to the prior art method, and which thus exhibits excellent superconductivity and high mechanical strength as compared to the superconductor produced by the prior art method.

With this and other objects in view, the present invention provides a method of producing a superconductor including a superconductive oxide.

It is one of the objects of the present invention to provide an economical and effective method for making superconductive materials in a tape form or in a membrane form which is suitable for mass production. An object is to provide a method for making superconductive tapes and membranes by which the produced material has enough superconductivity. Another object of the present invention is to provide superconductive tapes and membranes covered by a metallic layer.

According to a first aspect of the present invention, there is provided a method for making a superconducting tape including a superconducting oxide represented either by the formula

$$A_xB_yC_zD_{7-d}$$

provided that the A is at least one selected from the group consisting of Sc, Y, La, Ce, Pr, Nd, Pm, Sm, Eu, Gd, Tb, Dy, Ho, Er, Tm, Yb and Lu, the B is at least one selected from the group consisting of Be, Sr, Mg, Ca, Ba and Ra, the C includes Cu, the D includes O, x being between about 0.1 and 2, y being between about 1 and 3, z being between about 1 and 3 and d between about 0 and 5, or by the formula

$$A_xB_yCa_zCu_iO_j$$

where the A includes Bi or Tl, the B includes Sr or Ba, x is between about 1 and 3, y between about 1 and 3, z between about 1 and 3 and i between about 0 and 4. The method comprises the steps of:

(a) pressing at least one material, being of a starting material powder of the superconducting oxide, a powder of the superconducting oxide, or a compact made of the starting material powder and/or the superconducting oxide powder, for forming a filling material;

(b) charging said filling material into a metallic pipe to form a preform;

(c) rotary swaging said preform to produce a compact having a density of not less than 75% of the theoretical density corresponding to zero porosity;

(d) roll pressing said compact to make a composite in a tape form having a metallic covering made of the metallic pipe and a core covered by the metallic covering; and

(e) heat treating the tape formed composite in an oxygen-containing atmosphere.

Another aspect of the present invention is directed to a method of making a superconducting tape as mentioned above, wherein however A includes Bi or Tl.

In the drawings:

Fig. 1 is an enlarged cross-sectional view of a preform according to the present invention;

Fig. 2 is an enlarged cross-sectional view of a modified form of the preform in Fig. 1;

Fig. 3 is an enlarged cross-sectional view of a composite wire produced by diameter reducing the preform in Fig. 1;

Fig. 4 is a diagrammatic illustration of a rotary swaging machine, in which a composite wire of the preform in Fig. 2 is introduced;

Fig. 5 is a diagrammatic illustration of another swaging machine for further swaging the composite wire processed in the swaging machine in Fig. 4;

Fig. 6 shows a superconductive material in a tape form, produced according to the method of the invention;

Fig. 7 shows a composite bar composed of a superconductive material or base materials and a tube enclosing the former, as used in the method of the invention;

Fig. 8 shows a diametrical reduction process of the composite bar;

Fig. 9 is a cross-section of a composite bar;

Fig. 10 is a cross-section of an assembly comprising several composite bars;

Fig. 11 shows a diametrical reduction process;

Figs. 12 to 14 show an assembly after rolling;

## Detailed Description of the Invention

### The superconductive oxide

In the $A_xB_yC_zD_{7-d}$ superconductor of the present invention, the C may include Cu or Cu plus at least one element among Ag, Au and Nb and the D may contain O or O plus at least one element among S, Se, Te, Po, F, Cl, Br, I and At. Specific examples are: $Ba_{0.1}Sr_{0.05}La_{1.5}Yb_{0.35}CuO_{3.2}F_{0.8}$; $Ba_{0.1}Sr_{0.05}La_{1.5}Yb_{0.35}Cu_{0.9}Ag_{0.1}O_{3.2}F_{0.8}$; and $Ba_{0.1}Sr_{0.05}La_{1.5}Yb_{0.35}Cu_{0.9}Au_{0.1}O_{3.2}F_{0.8}$. In $Y_xBa_yCu_zO_{7-\delta}$ superconductor, preferably x=1, y=2, z=3, $0 < \delta < 1$, typically $\delta$ is about 0, and the oxide superconductor is orthorhombic. In $La_{2-k}B_kCuO_4$, preferably $0 < k < 0.3$ and typically, k = 0.15. Typical examples of the $A_xB_yCa_zCu_iO_j$ are $Bi_2Sr_2Ca_2Cu_3O_j$, $Bi_2Sr_2Ca_1Cu_2O_j$, $Tl_1Ca_2Ba_3Cu_4O_j$, $Tl_2Ca_2Ba_2Cu_3O_j$, $Tl_2Ca_2Ba_1Cu_3O_j$.

### The filling material

The filling material according to the present invention may include: a starting material power, including the elements which constitute the oxide superconductor; a green compact of such a starting material power; calcined green compact of the starting material powder; and a superconducting material obtained by sintering the green compact or by pulverizing the sintered compact. The filler may be in the form of powder, granule, compacted body of such a material or a mixture thereof.

The starting material power may contain: for example, a mixture of a powder of the A element or elements, a powder of a carbonate of the B element or elements, and a powder of the C element or elements; a pulverized, calcined powder of such a mixture; or a like powder. The powder of IIIa group elements, Sc, Y, La, Ce, Pr, Nd, Pm, Sm, Eu, Gd, Tb, Dy, Ho, Er, Tm, Yb and Lu, may be in the form of a powder of a compound such as a carbonate, oxide, chloride, sulfide, oxalate and fluoride thereof and in the form of an alloy powder thereof. As the IIIa group powder, an oxide powder thereof with a particle size about 5 $\mu$m or smaller is preferably used. The powder including Bi may be a powder of an oxalate thereof and the powder containing Tl may be a powder of $Tl_2O_3$. The powder of IIa group elements, may be in the form of a powder of a compound such as a carbonate, oxide, chloride, sulfide, oxalate and fluoride thereof and in the form of an alloy powder thereof. As the IIa group powder, a carbonate powder thereof with a particle size about 3 $\mu$m or smaller is preferably used. The powder

3

containing copper may be a powder of a copper oxide including CuO, $Cu_2O$, $Cu_2O_3$ and $Cu_4O_3$. A CuO powder of a particle size of about 3 $\mu$m or smaller is preferably used. The mixing ratio of these compounds depends on a desired superconductor. For $Y_1Ba_2Cu_3O_{7-d}$, $Y_2O_3$, $BaCO_3$ and CuO powders are preferably mixed so that Y : Ba : Cu = 1 : 2 : 3 at mole ratio. The starting material powder may have a particle size of about 4 $\mu$m or smaller, preferably about 1 to about 2 $\mu$m. Within such a preferable range, excellent heat diffusion of elements of the superconductive oxide may occur.

The starting material powder for the A-B-Cu-O superconductor may be prepared by the following so-called sol-gel method. An aqueous solution of the A element, the B element and Cu is prepared by weighing a soluble salt, such as a nitrate and acetate, of these elements at predetermined ratio, and then by dissolving them into a predetermined amount of water. The total concentration of the salts of these elements in the aqueous solution is preferably about 0.5 to about 10 wt.% but it depends on the kind of the soluble salt. Such an aqueous solution may be prepared by dissolving an oxide or carbonate of each element by an aqueous solution of nitric acid or acetic acid. Then, an acid, preferably carboxylic acid such as citric acid, succinic acid and tartaric acid, is added to the aqueous solution of the elements. About 5 to about 20 wt.% of citric acid is used per 100 wt.% of the aqueous solution. The amount of the other acids depends on the kind thereof. The acid added aqueous solution is then neutralized by adding a basic material, such as ammonia, ammonium carbonate, guanidine and ammonium acetate, to obtain a neutralized aqueous solution of about pH 7. As the basic material, an aqueous ammonia is preferably used. Then, the neutralized aqueous solution is heated to evaporate water and further to decompose or pyrolize the acid material and basic material, so that a solid sponge material (mixture) of oxides or carbonates, such as Y2O3, BaCO3 and CuO, of each element of the oxide superconductor is obtained. Subsequently, the sponge material is heated for burning and is then pulverized by a ball mill or automatic mortar for a predetermined particle size. The burnt sponge material is an aggregate of fine particles with a particle size of about 0.1 to about 0.6 $\mu$m and hence it is easy to produce fine powder mixture of a particle size of about 0.1 to about 0.6 $\mu$m by pulverizing. The fine powder is calcined as described hereinafter.

An alternative method for preparing the starting material is the following so-called coprecipitation method, in which an aqueous solution of the elements is prepared in the same manner as the sol-gel method above-described. A precipitant, such as oxalic acid, potassium oxalate, potassium carbonate and sodium carbonate, is added to the aqueous solution. The amount of the precipitant depends on its kind. Precipitation is carried out by controlling pH of the aqueous solution by adding a basic material, such as an aqueous ammonia, ammonium carbonate and potassium hydroxide. When oxalic acid is used as the precipitant, pH is set to about 4.6 and when potassium carbonate is used, it is controlled to about 7 to about 8. The coprecipitate is heated at about 100 to about 200°C, preferably about 150°C, for drying and then it is calcined about 700 to about 900°C for about 50 hours in a flowing oxygen atmosphere preferably including about 90 vol. % or more of oxygen. Then, the calcined material is pulverized by a ball mill or a mortar for a predetermined particle size of the starting material powder..

The filling material may be calcined at about 500 to about 1000°C for about 1 to about 100 hours in an oxygen atmosphere, including oxygen gas with an oxygen purity of 90 % or more, preferably nearly 100 %, for removing carbonates and carbon which are contained in it. When the high purity oxygen gas is forced to flow within the calcining furnace without standing, no significant problems are encountered but preferably, the flow rate is about 40 cm/min or more. The calcining may be repeated if necessary. Subsequently, the calcined filling material may be pulverized for a predetermined particle size, for instance, with a ball mill, mixed and then pressed into a bar-shaped compact by conventional methods, for example, cold hydrostatic pressing, such as rubber pressing using a rubber shell and hot hydrostatic pressing, for providing a predetermined green density. The compacting pressure may be about 1.5 to about 10 metric tons/cm², preferably about 1 to about 5 metric tons/cm² although it depends on the kind of the calcined material and on the predetermined green density. The calcining, the pulverizing and pressing operations may be repeated. With such operations, a green density of the compact may be 60 % or more of the theoretical density which has zero porosity. It is preferable to obtain a compact of a green density about 70 % or more of the theoretical density.

The calcined, pulverized filling material may be charged into a rubber tube, having one closed end, which is evacuated in a vacuum chamber to a vacuum level, for instance, about $10^{-4}$ mmHg, for reducing blowholes in the core heat treated and then is sealed by closing the other open end also in the vacuum chamber. The sealed tube may be wrapped with a soft synthetic resin sheet such as of a polyvinyl chloride resin for enhancing sealing thereof. Then, the rubber tube, wrapped with the synthetic resin, is pressed by means of a hydrostatic rubber press machine to form a compact in the same manner as in the forming of the bar-shape compact above described. The compact thus prepared has little air holes and hence has a relatively high green density and little cracks. This compact may be subject to the subsequent intermediate sintering described below. Then, the compact may be heated at about 700 to about 1100°C for about 1 to about 100 hours, preferably at about 800 to about 1000°C and more preferably at about 850 to about 950 °C for about 1 to about 50 hours, in an oxygen atmosphere. With such an intermediate sintering, the sintered compact may have a sintered density of about 75 % or more of the theoretical density. This sintered density of about 75 % or more provides preferable sintered density, that is, about 82 % or more, of the sintered core of the composite wire by a heat treatment with ease after subsequent forging or cross-sectional area reduction which will be hereinafter described.

When the sintered density of a sintered compact which has been subjected to the intermediate sintering is set to about 70% to about 75%, the diameter reduced core thereof may have a green density of about 75% to 85% of the theoretical density which provides a sufficient amount of oxygen to the inside of the core 22 having no sheath during subsequent heat treatment for producing a superconductive oxide, so that the sintered core having an excellent superconductivity may be produced with a sintered density of about 90% or more of the theoretical density.

The filling material of the superconductive material may be prepared by calcining the starting material powder at about 500 to about 1000°C for about 1 to about 50 hours, pressing the calcined powder to form a compact in a similar manner above described, and then heating the compact for about 700 to about 1100°C for about 1 to about 100 hours in an oxygen atmosphere or oxygen-containing atmosphere, which will be stated in more detail in paragraphs entitled "The heat treatment", for producing a superconductive oxide. For Y-Ba-Cu oxide superconductor, the compact is heated preferably for about 800 to about 1000°C for 1 to about 50 hours. Thereafter, the heat treated compact is pulverized to obtain a predetermined particle size of the superconducting material powder. These pressing, heating and pulverizing operations may be repeated for producing a superconducting material powder of a homogeneous composition. The superconducting material powder is selected with a conventional method, such as sedimentation, to have a particle size of, typically, about 1 μm or smaller and preferably about 0.7 μm to about 1.5 μm. The superconducting material powder thus selected may be pressed and then subjected to intermediate sintering in the same manner as previously described.

## The metallic pipe

The metallic pipe according to the present invention may be made of, for example, copper, a copper alloy, a noble metal such as silver, gold and platinum, an alloy of such a noble metal, aluminum and a stainless steel. The pipe may be made of other metals or plastic materials other than metals. When the metallic sheath is not removed after the cross-section reduction of the preform and the composite is directly subjected to the heat treatment hereinafter described in detail, the pipe should be made of an unoxidizing material which does not take oxygen away from the core of the composite during heat treatment for producing an oxide superconductor. For this reason, noble metals above-mentined or alloys containing noble metals are preferably used, but use may be made as the pipe a pipe, made of any oxidizing material, which is coated at its inner face with an coating of such an unoxydizing material or a like material for preventing oxygen from being taken away during the heat treatment.

The thickness of the metallic pipe is preferably about 10 to about 25 % of the outer diameter thereof. The lower limit of the thickness of the metallic pipe should be such that it does not produce a breaking of the diameter reduced composite wire having a predetermined diameter. The upper limit is determined in view of both the pressure transmittance to the core and the cost of the metallic pipe.

## The preform

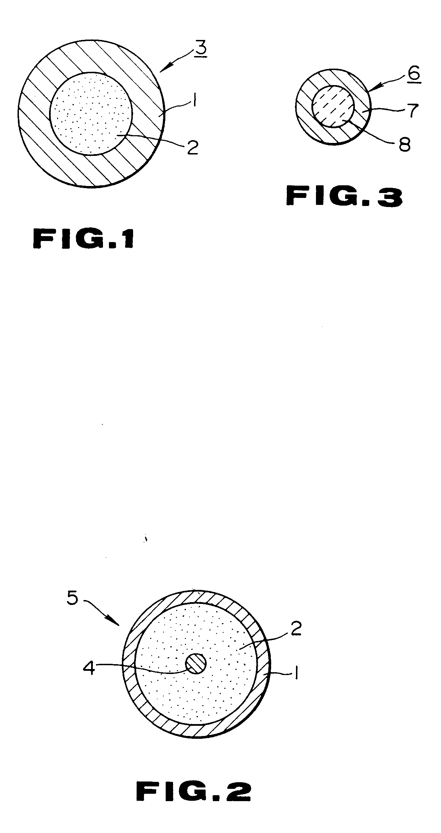

The filling material is charged into the metallic pipe to form a preform. FIG. 1 illustrates a preform 3 which may be, according to the present invention, prepared by inserting a compact 2, made of a superconductor powder, into the metallic pipe 1. The compact 2 may be made by presseing and then sintering a green compact of the superconducting material into a cylindrical shape. The temperature of the sintering may be about 400 to about 1000 °C. The compact 2 may be made with a rubber shell in a conventional hydrostatic press machine. It is preferable that the gap between the compact 2 and the metallic pipe 1, which fits around the compact 2, is as small as possible so that forging pressure may be sufficiently applied to the core compact in the subsequent diameter reduction.

As illustrated in FIG. 2, the filling material 2 may be, according to the present invention, charged into a metallic pipe 1 into which a core wire 4 is concentrically arranged to form a preform 5. The core wire 4 is made of a non-oxidizing material which does not take oxygen away from the filling material 2 in the metallic pipe 1 during the subsequent heat treatment. The core wire 4 should have a high tensile strength with a melting point higher than about 800°C and may include, for example, a metal wire, such as of silver, gold, platinum, titanium, tantalum and a silver alloy, and a ceramic fiber such as a carbon filter, silica fiber and alumina fiber. The cross-sectional area of the core wire 4 has preferably about 10 % or less of the cross-sectional area of the filling material 2 charged in the metallic pipe 1. With about 10 % or less, the core wire 4 provides excellent effects to the superconductor in raising green density of the core of the composite wire and in mechanical strength thereof.

## The diameter reduction

In the present invention, the preforms 3 and 5 may be conventionally diameter reduced and formed into a composite wire 6 by well-known methods, for example, drawing with a die, rolling with grooved rolls or swaging such as rotary swaging, to a predetermined diameter. The diameter reduced composite wire 6 has a metallic sheath 7 and a core 8 sheathed with the sheath 7. The diameter reduction operation may be repeated. It is preferable that the forging ratio F is within a range about 10 % to about 40 % for each diameter reduction operation in which F is defined by the formula

$$F = (S_1 - S_2) \times 100/S_1$$

where $S_1$ and $S_2$ are cross-sectional area of the preform 3, 4 and the diameter-reduced preform or composite wire 6, respectively. Below about 10 % of the forging ration F, the number of the diameter reduction operation is rather increased. Beyond about 40 %, it takes rather long period of the processing time.

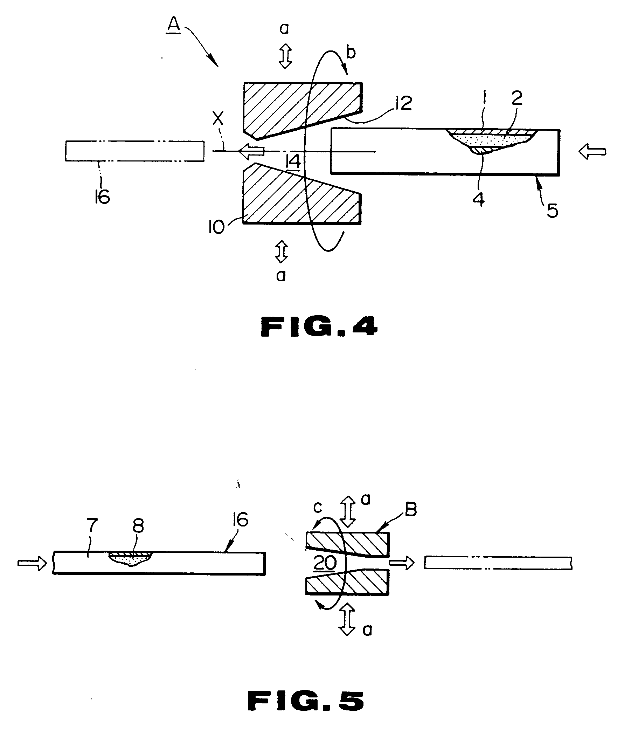

The preforms 3 and 4 are diameter reduced by rotary swaging using a conventional rotary swaging machine A as in FIG. 4, in which a plurality of dies 10 are arranged about an axis X thereof and are forced to be axially moved (in the direction of the arrow a) during rotating about the axis X (in the direction of the arrow b). The rotary swaging machine A is arranged so that the dies 10 surround the traveling path of the preform 5. The dies 10 are supported to be movable perpendicularly to and to be rotatable about the traveling path. Each of the dies 10 has an inclined face 12 inclined to the axis X so that the inclined faces 12 thereof define a substantially conical working space 14 tapering forwards.

In diameter reduction, the rotary swaging machine A is actuated and then one end of the preform 5 is pushed into the tapering working space 14 of the rotary swaging machine A along the traveling path thereof. The preform 5 is diameter reduced from its one end by the dies 10, which are radially reciprocated and rotated about the axis X, and it is thereby shaped into a composite wire 16 and hence the rotary swaging provides a fairly large forging ratio to the preform 5 as compared to other conventional forging methods. In this rotary swaging machine A, the processing speed or the traveling speed of the preform 3, 5 through it is preferably about 0.1 m to about 10 m/min.

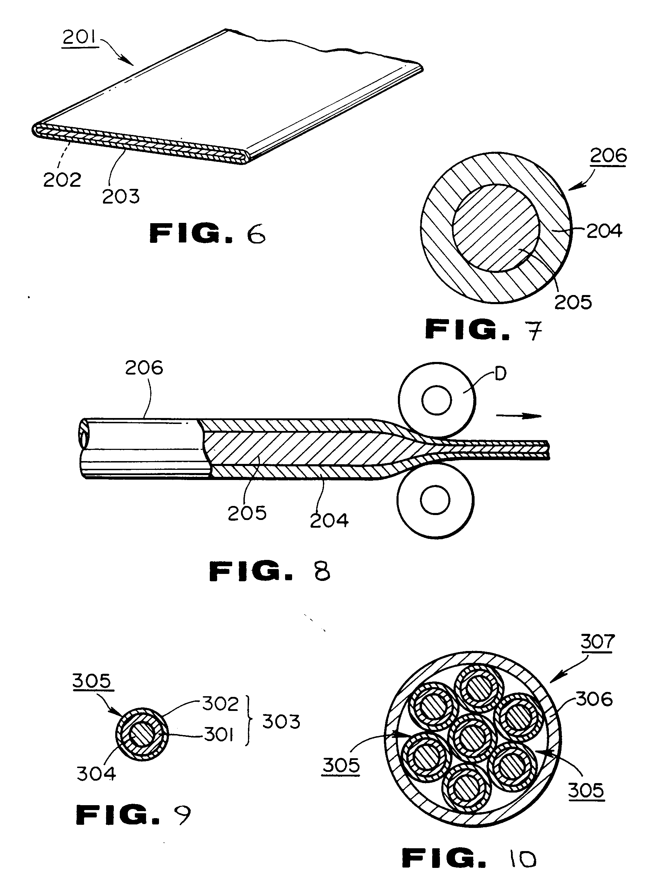

When needed, the composites 6, 16 may be further diameter reduced to a predetermined diameter by means of another rotary swaging machine B in FIG. 5 which has a conical working space 20 smaller than that of the first rotary swaging machine A. In this second diameter reduction, the composite 6, 16 is swaged from the other end to the one end while in the first diameter reduction, it has been diameter reduced from the one end to the other end. Such change in the swaging direction along the axis X provides an increase in green density of the core 8 in the sheath. The swaging operation may be repeated more than twice, in which case the direction of swaging may be changed in each operation or with intervals of a predetermined number of swaging.

The composite wire 6, 16 undergoes the rotary swaging until the green density of the core 8 reaches to about 75 % or more, preferably to about 77 % or more of the theoretical density. With the green density of less than about 75%, superconductivity of the produced oxide superconductor may be degraded since there is an upper limit of increase in density of the core in the the subsequent heat treatment, which will be described hereinafter. The core of composite wire 6, 16 may have a green density of about 75% or more by other conventional methods such as die forging.

## Other preferred modes of the Invention

It has been discovered that when superconducting materials are calcined or sintered at high temperatures for a long period of time for enlarging crystal grains, clearances between crystal grain may excessively increase, so that oxide superconductors produced may be rather degraded in critical current density. For reducing this drawback, calcining, intermediate sintering and sintering operations may be carried out in the following conditions although other production conditions of which description is omitted are the same as as hereinbefore described. The filling material may be calcined about 800 to about 950°C for about 6 to 50 hours. Under these conditions, the particle size of the calcined material may be 10 μm or smaller. The calcining temperature is preferably about 850 to about about 920°C. Within this temperature range, the calcined material may have a particle size of 5 μm or smaller, which material facilitates the producing of a superconducting material having a particle size of 10 μm or smaller after intermediate sintering. In the intermediate sintering, a compact, which may be prepared in the same conditions as previously described in the subtitle "The filling material", is subjected to the intermediate sintering at about 800 to about 950°C, preferably 850 to about 920°C, for about 6 to about 50 hours in oxygen atmosphere and then may be gradually cooled to thereby produce an intermediate sinter rod. The preferable temperature range facilitates to produce an intermediate sintering with fine crystal grains equal to 10 μm or smaller.

A solidified material which is made of a molten starting material may contain excellent oxide superconductors and from the solidified material an excellent superconductor with relatively high critical current density may be produced. According to this modified method, the superconductor is produced in the same conditions as previously stated except the following. The starting material powder, already stated in connection with "The filling material", is calcined at about 750 to about 950°C for about 3 to about 50 hours and then pulverized to a predetermined particle size. Subsequently, the calcined powder is subjected to intermediate sintering at about 800 to about 950°C for about 3 to about 50 hours and then cooled to produce a superconductive oxide powder. For producing Bi-Sr-Ca-Cu oxide superconductor, the calcined powder undergoes intermediate sintering preferably at 890°C for 20 min. and then at 880 °C for 9 hours, after which it is rapidly cooled. For Y-Ba-Cu oxide superconductor, the slow cooling previously described, which includes transformation to a rhombic system, is preferably made. The sintered powder is placed in a platinum or CaO crucible where it is heated at about 1300°C in an oxygen containing atmosphere to produce a molten material, which is solidified by rapid cooling to a temparature of about 800 to about 950°C. This rapid cooling may be carried out by taking out the crucible, containing the molten material, from the heating appliance and placing it in the atmosphere. Alternatively, the crucible may be forcedly cooled by using a coolant. After maintained at the temperature about 800 to about 950°C for about several to about several tens hours, the solidified material is cooled to room temperature. The cooling to the room temperature may be rapidly made for Bi-Sr-Ca-Cu-O system superconductor. The slow cooling as previously described, which includes transformation to a rhombic system, is preferable for Y-Ba-Cu oxide superconductor. A surface portion of the solidified material thus obtained is cut with a thickness 1 mm or smaller, preferably about several μm to about several hundreds μm by machining and is then pulverized to produce a surface powder which contains high purity and homogeneous superconductive oxide. The remaining solidified material is remelted and reused for obtaining the surface power in the same manner. Such a powder may be directly obtained by injecting the molten material into the atmosphere at about 800 to about 950°C with a carrier gas. However, the powder should have a particle size of about several hundreds μm or smaller. These powders, obtained from the solidified material, may be pressed to form the bar-shaped compact, already stated, which may be heat treated at about 800 to about 950°C for about 6 to about 50 in an oxygen atmosphere to increase the content of the oxide superconductor.

In the following examples, Examples 1, 1A and 2-23 (and the associated comparative tests) illustrate the physical characteristics of the superconducting oxides used in the method of the present invention, when processed at least partly in accordance with that method. Examples 24 and 25 describe methods for making a superconductor tape in accordance with the present invention.

## Example 1

Powders of $Y_2O_3$, $BaCO_3$ and CuO were mixed at mole ratio Y: Ba: Cu = 1 : 2 : 3 to obtain a starting material powder mixture, which was calcined at 900°C for 24 hours in the atmosphere and then pulverized to produce a calcined powder. This calcined powder was pressed by a rubber press to form a compact, which was heated at 900°C for 24 hours and then gradually cooled to produce a rod containing a superconductive oxide $Y_1Ba_2Cu_3O_{7-\delta}$ of which critical current density was about $40A/cm^2$. The rod had a sintered density of about 75%. The rod was inserted into a silver pipe having an outer diameter 10 mm and inner diameter 7mm to form a preform, which was cold forged in a stepwise manner by a rotary swaging machine as illustrated in FIGS. 4 and 5 to produce a composite wire with a diameter 1.5 mm without breaking. This cold forging was carried out at a processing speed of 1 m/min with a forging ratio of about 20% for each diameter reduction. The sintered density of the core of the composite was more than about 75%. The silver sheath of the composite wire was removed by placing it in nitric acid to expose the core. The exposed core was heated at 850 to 950°C for 24 hours and then gradually cooled to room temperature at a speed of -100°C/hour to produce a superconductor. The superconductor exhibited a critical temperature (Tc) of 91K and a critical current density (Jc) of about 10000 $A/cm^2$ at 77K. This superconductor could be wound around a magnet core without crack and showed a sufficient mechanical strength.

## Example 1A

A superconductor was prepared in the same manner and conditions as in Example 1 with the starting material powders of a particle size about 2 μm. In this Example, the pulverized, calcined powder had a particl size about 10μ and was pressed at 3 metric tons/cm² to form the compact, having a green density about 65% of the theoretical density, which compact was heated in ambient flowing oxygen of 2 liters/min and subsequently gradually cooled at -200°C/hour to produce the superconducting rod which had a sintered density about 75%. The exposed core was subjected to the final heating in ambient flowing oxygen of about 2 liters/min and then gradually cooled to produce an oxide superconductor, of which sintered density was about 95% of the theoretical density. The superconductor thus produced exhibited a critical temperature of 91K and a critical current density of about 10000 A/cm$^2$ at 77K.

Comparative Tests 1 and 2

Two oxide superconductors were prepared in the same conditions and manner as the Example 1 except that sintered density of compacts for Comparative Tests 1 and 2 were 65% and 70% respectively. The superconductors of Comparative Test 1 and 2 exhibited critical current density of 200 A/cm$^2$ and 500 A/cm$^2$, respectively.

Example 2

Powders of $Y_2O_3$, $BaCO_3$ and $CuO$ were mixed at ratio Y: Ba: Cu = 1 : 2 : 3 to obtain a powder mixture, which was calcined at 900°C for 24 hours in the atmosphere. This calcined powder was pressed to form a compact, which is heated at 900°C for 24 hours and then pulverized. These pulverizing, pressing and heating operations were repeated three times to produce a superconductive powder containing a superconductive oxide $Y_1Ba_2Cu_3O_{7-\delta}$, from which a superconducting powder of 0.5 to 1 µm particle size was obtained by coprecipitation method and was pressed by hydrostatic pressing at pressure of 2.5 ton/cm$^2$ to produce a rod-shaped compact of 6.5 mm diameter, which was heated at 900°C for 24 hours in an oxygen atmosphere to obtain a first sinter, of which sintering density was 75% of the theoretical density. The first sinter was inserted into a silver pipe having the same silver pipe in Example 1 to form a preform, which was cold forged in the same manner as in Example to obtain a 1.5 mm diameter composite wire without breaking thereof. The sintered density of the core of the composite wire was about 80% of the theoretical density. The composite wire was subjected to the removing of the silver sheath, the heat treatment and the slow cooling in the same conditions as the Example 1 except that the final heat treatment was carried out for 12 hours instead of 24 hours. The heat treated, exposed core was coated with a 1 mm thick solder coating by plating to produce a superconductor. The superconductor was equal to superconductivity in critical temperature and critical current density to the superconductor of Example 1 and also showed an excellent mechanical strength in winding around a magnetic core.

Comparative Tests 3 and 4

Two oxide superconductors were prepared in the same conditions and manner as the Example 1 except that sintered density of the core in the sheath was smaller than 75% and sintered density of compacts for Comparative Tests 3 and 4 were 80% and 85% respectively. The superconductors of Comparative Tests 3 and 4 exhibited critical current density of 200 A/cm$^2$ and 500 A/cm$^2$, respectively.

Example 3

Powders of $Y_2O_3$ with particle size 4 µm or smaller, $BaCO_3$ with particle size 1 µm or smaller, and $CuO$ with particle size 1 µm or smaller, of which each powder had purity of 99.9% or more, were mixed with a ball mill at mole ratio Y: Ba: Cu = 1 : 2 : 3 to obtain a powder mixture, which was calcined at 900°C for 24 hours in ambient flowing oxygen. This calcined powder was pulverized and then pressed to form a round bar shaped compact at 2500 Kg/cm$^2$. This series of heating, pulverizing and pressing operations were repeated three times to produce a 6.5 mm diameter bar-shaped calcined compact, of which sintered density was about 90% of the theoretical density. The rod was inserted into the same silver pipe as in Example 1 and was obtained a 1.5 mm diameter in the same manner as in Example 1 except for forging ratio of 10% per each pass. The sintered density of the core of the composite wire was about 80% of the theoretical density. The composite wire was subjected to the removal of the sheath, the final heating and slow cooling in the same conditions and manner as in Example 1 except that the final heat treatment was carried out at 890 °C for 17 hours. The superconductor thus produced, of which sintered density was 93% of the theoretical density, exhibited a critical temperature of 91K and about 11,000 A/cm$^2$ at 77K and also showed an excellent mechanical strength in winding a magnetic core.

Example 4

A calcined compact of which green density was about 62 % was prepared in the same conditions and manner as in Example 3, and then heated at 900°C for 24 hours in ambient flowing oxygen with subsequent slow cooing to produce a round-rod-shaped intermediate sinter, containing a superconductive oxide $Y_1Ba_2Cu_3O_{7-\delta}$ ($0 \leqq \delta \leqq 5$), of which sintered density was about 72%. The intermediate sinter was inserted into a silver pipe having the same silver pipe in Example 1 to form a preform, which was cold forged in the same manner as in Example to obtain a 1.5 mm diameter composite wire without breaking thereof. The composite wire was subjected to the removing of the silver sheath, the heat treatment and the slow cooling in the same conditions as the Example 1 except that the final heat treatment was carried out at 890°C for 17 hours. With the final heat treatment, a sinter with a sintered density of about 92% was obtained. The superconductor thus produced exhibited a critical temperature of 91K and about 11,000 A/cm² at 77K and also showed an excellent mechanical strength in winding a magnetic core.

Comparative Tests 5 and 6

Two oxide superconductors were prepared in the same conditions and manner as the Example 4 except that green density of the calcined compact for Comparative Test 5 and 6 were 50% and 55%, respectively. The superconductors of Comparative Tests 5 and 6 had sintered density of 80% and 85% and exhibited critical current density of 200 A/cm² and 500 A/cm², respectively.

Example 5

The compact was prepared in the same conditions and manner as in Example 2 except that the powder mixture was calcined in a heating furnace with flowing 100 % purity oxygen of 80 cm/min. The pulverizing, pressing and heating operations were repeated also three times to obtain the compact, which was inserted in the same silver pipe as in Example 2 and then diameter reduced by using a rotary swaging machine to produce a composite wire with 1.5 mm outer diameter. The sheath of the composite wire was removed with an acid to expose the core, which was heated at 890°C for 17 hours and then gradually cooled to produce a superconductor wire, of which critical current density Jc at 77K and oxygen defect rate $\delta$ are given in Table 1.

Comparative Tests 7-10

Oxide superconductors were prepared in the same conditions and manner as in Example 5 except that calcining was carried out for oxygen concentration of 21%, which corresponds to the atmosphere, to 80%. The critical current density Jc at 77K and oxygen omission rate d of each superconductors are given in Table 1, from which it would be clear that a superconductor calcined with an oxygen concentration of 90 % or more provides excellent superconductivity.

Table 1

| | Ex.5 | Comparative Tests | | | |
| | | 7 | 8 | 9 | 10 |
|---|---|---|---|---|---|
| Oxygen Concentration(%) | 100 | 80 | 60 | 40 | 21 |
| Jc (A/cm²) | >10⁴ | 2000 | 1200 | 920 | 640 |
| d | 0.05 | 0.19 | 0.31 | 0.35 | 0.40 |

Example 6

Powders of $Y_2O_3$, $BaCO_3$ and $CuO$ were mixed at ratio Y: Ba: Cu = 1 : 2 : 3 to obtain a powder mixture, which was calcined at 900°C for 24 hours in ambient flowing oxygen and then pulverized to produce a calcined powder. This calcined powder was pulverized and then placed within a rubber tube, having 7 mm inner diameter, which was in turn pressed by a rubber press at 2.5 ton/cm² to form a compact. The compact was heated at 900°C for 24 hours. These pulverizing, pressing and heating operations were repeated three times to produce a sinter with an outer diameter 6.9 mm, of which density was 4.5 g/cm³. The sinter was placed within the same silver pipe as in Example 1 and then subjected to cold forging, removal of the sheath and the final heat treatment also in the same conditions and manner as in Example 1 except that the core was heated at 900°C for 12 hours in an oxygen atmosphere. The core thus obtained was coated by plating with a 1 mm thick solder protection layer. was carried out at a processing speed of 1 m/min with a forging ratio of about 20% for each diameter reduction. The sintered density of the core of the composite was more than about 75%. The silver sheath of the composite wire was removed by placing it in nitric acid to expose the core. The exposed core was heated at 850 to 950°C for 24 hours and then gradually cooled to room temperature at a speed of -100°C-/hour to produce a superconductor. By repeating these operations, samples of the superconductor was prepared. Densities of the cores after the sheath removal and heat treated are given in Table 2 as well as its critical current density Jc at 77K.

Comparative Test 11

Oxide superconductors were prepared in the same conditions and manner as in Example 6 except that the calcined powder was directly inserted into the silver pipe without being pulverized and pressed. The density of the core before swaging was 3.5 g/cm³. Densities of the core after the sheath removal and heat treated are given also in Table 2 as well as its critical current density Jc at 77K.

## Table 2

| | Ex. 6 | Comparative Test 11 |
|---|---|---|
| Density after removal of the sheath (g/cm³) | 4.9-5.1 | 4.0-4.3 |
| Density after the heat treatment (g/cm³) | 5.8-5.9 | 5.2-5.4 |
| Jc (A/cm²) | 7000-10000 | 40-980 |

Example 7

Superconductors were prepared in the same conditions and manner as in Example 6 except that the diameter reduction was conducted by drawing with a die for each sample. The experimental results are given in Table 3.

Comparative Test 12

Superconductors were prepared in the same conditions and manner as in Comparative Test 11 except that the diameter reduction was conducted by drawing with a die for each sample. The experimental results are given in Table 3.

## Table 3

| | Ex. 7 | Comparative Test 12 |
|---|---|---|
| Density after removal of the sheath (g/cm³) | 4.7-4.9 | 3.9-4.1 |
| Density after the heat treatment (g/cm³) | 5.6-5.7 | 5.0-5.1 |
| Jc (A/cm²) | 1100-2000 | 25-640 |

Example 8

Powders of $Y_2O_3$, $BaCO_3$ and CuO were weighed 9.0791g, 31.7451g and 19.1858g, respectively, so that Y : Ba : Cu = 1 : 2 : 3 and placed in beaker, into which was poured 80ml of 60% nitric acid aqueous solution for completely dissolving the powders to obtain a starting powder solution, to which were added 120g of citric acid and fully stirred for complete dissolution. Then, 28% aqueous ammonia was added for neutralization to thereby obtain a pale transparent (neutralized) solution of pH 7, which which was subsequently heated at 200°C with the result after water was evaporated, a porous mass was pyrolized and burnt, so that sponge material was obtained, which was confirmed by X-ray diffraction to be a mixture of $Y_2O_3$, $BaCO_3$ and CuO. The mixture was pulverized in an automatic mortar for 30 minutes to produce a powder of a particle size about 0.1 to about 0.6 $\mu$m, which was calcined for 900°C for 24 hours in ambient flowing oxygen. The calcined powder was then further pulverized by a ball mill to produce a pulverized powder, which was pressed at 2.5 metric tons/cm$^2$ to form a compact bar, which was in turn heated at 890°C for 12 hours in an oxygen gas atmosphere. This series of pulverizing, pressing and heating operations was repeated three times to obtain compact with 6.9 mm diameter, which subsequently underwent sheathing, rotary swaging, sheath removing, and final heating in the same conditions and manner as in Example 1 except that the final heating was carried out at 890°C for 12 hours, followed by slow cooling. The composite wire after swaging and the core of the superconductor had sintered density of 82% and 91% or more, respectively. The superconductor exhibited a critical temperature of 91 K and critical current density of about 11000 A/cm$^2$ at 77K.

Example 9

With control of pH 7 to 8 by adding 28% aqueous ammonia, a precipitation was produced in the citric acid added solution which was prepared in the same conditions and manner as in Example 8 except that 70.9548g of citric acid was added to the starting material dissolved solution. The precipitation was dried at 150°C and it was confirmed by X-ray diffraction that it was a mixture of Y, Ba, Cu and O. The mixture was subjected to calcining, pressing, intermediate sintering, sheathing, rotary swaging, sheath removing, final heating and slow cooling in the same manner and conditions as in Example 8. The superconductor, thus produced, was equal in critical temperature and critical current density to the superconductor of Example 8.

Example 10

A pulverized, calcined powder was prepared by the same conditions and manner except the powder mixture was calcined at 850°C for 24 hours. It was observed by microscopy that the pulverized, calcined powder had an average particle size of 5 $\mu$m or smaller. The powder was pressed by a rubber press at 2.5 t/cm$^2$ to form a rod compact, which was heated at 850°C for 24 hours in an oxygen atmosphere and then gradually cooled at -200°C/hour to produce a round rod intermediate sinter, containing a superconductive oxide $Y_1Ba_2Cu_3O_{7-\delta}$, of which average particle size was confirmed to be 10 $\mu$m or smaller. The intermediate sinter was sheathed, underwent rotary swaging, and then removal of the silver sheath in a manner similar to the manner in Example 1 to produce an exposed core. The exposed core was subsequently heated at 850°C for 50 hours in an oxygen atmosphere and then gradually cooled to room temperature at a speed of -200°C/hour to produce a superconductor. The superconductor exhibited a critical temperature of 91K and about 10,000 A/cm$^2$ at 77K and had a density of 5.8 g/cm$^3$ at its superconducting portion.

Comparative Test 13

An oxide superconductor was produced in the same conditions and manner except that in each of the calcining, intermediate sintering and the final sintering, the heating temperature was 980°C. This superconductor has a density of 5.8 g/cm$^3$ at is superconducting portion.

Example 11

A calcined powder was prepared in the same conditions and manner as in Example 1 and then heated at 890°C for 14 hours in an oxygen atmosphere to produce $Y_1Ba_2Cu_3O_{7-\delta}$ superconductor, which was then placed in a platinum crucible, where it was heated at 1300°C in an oxygen atmosphere to melt. The molten material was rapidly cooled to 900°C in an oxygen atmosphere and was maintained at this temperature for 10 hours, after which it was gradually cooled to room temperature at -200°C/hour to form a solidified material. A surface layer of the solidified material was taken away and was pulverized to produce a powder, which was pressed with a rubber press to form a rod compact having 8 mm diameter. This rod was sheathed with a silver pipe having 15 mm outer diameter and 10 mm inner diameter to form a preform, which was diameter reduced by rotary swaging machine and drawing die for 1.0 mm diameter composite wire. The silver sheath was removed by dissolving with a dilute nitric acid for exposing the core, which was then heated at 890°C for 3 hours in an oxygen atmosphere to produce an oxide superconductor. This superconductor exhibited critical current density (Jc) of $1.6 \times 10^4$ A/cm$^2$ in zero magnetic field and $1.2 \times 10^4$ A/cm$^2$ in 2T magnetic field.

Example 12

Powders of $Y_2O_3$ with particle size 4 μm, $BaCO_3$ with particle size 1 μm, and CuO with particle size 1 μm were mixed with a ball mill at mole ratio Y: Ba: Cu = 1 : 2 : 3 to obtain a powder mixture, which was calcined, pulverized and then pressed to form a bar shaped compact in the same conditions and manner as in Example 3. This series of heating, pulverizing and pressing operations were repeated to produce a 6.9 mm diameter compact, of which sintered density was about 78% of the theoretical density with critical current density of about 40 A/cm$^2$. This compact was sheathed and underwent rotary swaging, removal of the sheath, the final heating and slow cooling in the same conditions and manner as in Example 3 except for forging ratio of 20% per each pass. The green density of the core of the composite wire after the rotary swaging was 82 % and the sintered density of the superconductive core was about 91.5 % of the theoretical density. The core was coated with 1 mm thick protective coating by solder coating. The superconductor thus produced exhibited a critical temperature of 91K and a critical current density of about 11,000 A/cm$^2$ at 77K and also showed a sufficient mechanical strength in winding a magnetic core.

Example 13

The starting material powder of Example 1 was calcined at the same temperature for 12 hours and then pulverized to form a calcined powder, which was heated at 890°C for 12 hours at ambient flowing oxygen of 2 liters/min. The heated powder was charged into a silver pipe having an inner diameter 7 mm and outer 7 mm with a 2 mm diameter silver core wire inserted into it to thereby obtain a preform, which was rotary swaged in a stepwise manner to have a diameter 1.4 mm with a forging ratio of about 10 % for each pass at a processing speed of 1 m/min. The composite wire thus obtained underwent sheath removal, final heating, and slow cooling in the same conditions and manner as in Example 1 except that the slow cooling was carried out at -200°C/hour to produce an oxide superconductor, which was then coated with a protection coating layer by solder plating to obtain a superconducting wire with an outer diameter 1 mm. The superconducting wire exhibited a critical temperature of 92K and a critical current density of about 12,000 A/cm$^2$ at 77K. This superconductor could be wound around a magnet core without any substantial crack and showed a sufficient mechanical strength.

Example 14

The starting material powder mixture of the Example 1 was calcined, pulverized and then pressed at 2.5 metric tons/cm$^2$ to form a rod compact in the same conditions and manner as in Example 1 except that the pulverized, calcined powder was charged into a rubber tube with inner diameter 7 mm and outer diameter 10 mm, which was then placed within a vacuum chamber held at a vacuum level about $10^{-4}$ mmHg. In this condition, the rubber tube was sealed and then pressed to form the rod compact, which was subsequently subjected to intermediate sintering, sheathing, rotary swaging, sheath removing, final heating and then slow cooling in the same conditions and manner as in Example 1 except that the rod compact underwent intermediate sintering for 12 hours in an oxygen atmosphere. The superconductor, thus obtained, exhibited a critical temperature (Tc) of 91K and a critical current density (Jc) of about 11,000 A/cm$^2$ at 77K.

Example 15

The starting material powder mixture was calcined at 700°C for 24 hours and then calcined 900°C for 24 hours to produce a calcined powder, which was then charged into a silver pipe having an inner diameter 7 mm and outer diameter 10 mm to form a preform, which was subjected to rotary swaging, sheath removing and final heating in the same conditions and manner except that the preform was diameter reduced to a diameter of 1.4 mm. In the rotary swaging, the preform was cold forged by changing traveling direction for each passing. The composite wire, thus formed, had a core with a diameter 0.8 mm. The superconductive core wire produced was coated with a 1 mm thick protection coating by solder plating. The superconductor was equal in critical temperature and critical current density to the superconductor of Example 1 and also showed sufficient mechanical strength.

## Example 16

A superconductive core wire was prepared in the same conditions and manner as in Example 1 except that after the rubber pressing, the rod compact was heated at 900°C for 24 hours in an oxygen atmosphere to produce a compact having a diameter 6.9 mm, of which sintered density was 78% of the theoretical density. The compact was then subjected to sheathing, rotary swaging, sheath removing and final heating in the same conditions and manner as in Example 1 except that the final heating was made at 900°C for 24 hours. The composite wire had a core of 82% green density of the theoretical density and the superconducting core had a sintered density of 91.5% of the theoretical density after the final heating. The superconductive core was coated with a 1 mm protective coating by solder plating to produce a superconductor, which was equal in critical temperature and critical current density to the superconductor of Example 1 and also showed a sufficient mechanical strength in winding a magnet core.

## Example 17

An oxide superconductor was produced in the same conditions and manner as in Example 2 except that the rod-shaped compact, formed by the hydrostatic pressing, had a diameter 7 mm and length of 100 mm, that the preform was diameter reduces so that the composite had a diameter 3 mm and length of about 234 m. The superconductor had a critical temperature of 91 K and critical current density of about 110000 A/cm². An excellent cutting was made to the superconductor by a diamond cutter with little cracks due to the cutting.

## Example 18

A superconducting powder including $Y_1Ba_2Cu_3O_{7-\delta}$ ($0 \leqq \delta \leqq 5$) was charged into an aluminum pipe having 10 mm outer diameter and 6 mm inner diameter to form a preform, which was diameter reduced by rotary swaging in a stepwise manner to form a composite with 1.5 mm outer diameter, which was in turn immersed in 50% sodium hydroxide for dissolving the aluminum sheath to expose the core. The exposed core was heated at 900°C for 5 hours in an oxygen atmosphere for producing an oxide superconductor, of which critical current density at 77K is given in Table 4.

## Comparative Tests 14 and 15

An aluminum sheathed composite wire was prepared in the same conditions and manner as in Example 18 and removed by dissolving with 50% sulfuric acid to obtain an exposed core for Comparative Test 14. Another composite wire was prepared for Comparative Test 15 in the same conditions and manner as in Example 18 except that a silver sheath of the same configuration was used. The silver sheath was removed with 50% nitric acid aqueous solution to exposed its core. The two exposed cores were heat treated in the same conditions as in Example 18 to produce superconductors, each of which had critical current density at 77K as given in Table 4.

Table 4

|  |  | Comparative Tests | |
| --- | --- | --- | --- |
|  | Ex. 18 | 14 | 15 |
| Critical current density (x 10³ A/cm²) | 23 | 4.9 | 5.2 |

## Example 19

Powders of $Y_2O_3$ (purity: 99.99%), $BaCO_3$ (purity: 99.9%) and CuO (purity: 99.9%) were weighed so that Y : Ba : Cu = 1 : 2 : 3 in mole ratio, and then mixed to obtain a powder mixture, which were calcined at 900°C for 24 hours in the atmosphere and then pulverized to produce a superconducting powder which includes an oxide superconductor $Y_1Ba_2Cu_3O_{7-\delta}$, The superconducting powder was pressed by a rubber press into a rod compact, which was heated at 890°C for 12 hours in ambient flowing oxygen gas of 2 liters/min to produce a sintered compact, which was in turn inserted into a copper pipe, having an inner diameter 8 mm and outer diameter 15 mm to form a preform. Subsequently, the preform was dawn into a composite wire having an outer diameter 1.5 mm and length 500 mm, of which core had a diameter 0.8 mm. The composite wire was wound around a reel and introduced at a speed of 20 mm/min into a heating tube as shown in FIG. 8, where it was induction heated to melt the sheath for exposing the core. The heating tube had five high frequency induction coils of which first one had a length L1 of 0.5 m and the others had a length L2 of 3 m. Each coil was supplied with 30 kHz to 100 kHz of alternating current. Thus, the coils were adjusted so that the first coil with 0.5 m length was provided with an output of 50 kW for enabling to melt the copper layer, which coated the core of the composite, and the other coils were provided with outputs of 20-100 kW for heating the exposed core of the composite at a temperature 890°C ± 5°C. In the slow cooling portion 42B of the heating tube had a length L3 5 m for gradually cooling the heated core. In the induction heating, the inside of the heating tube was place in an oxygen atmosphere by introducing hot oxygen gas at a flow rate of 2 liters/min via oxygen supply tubes 36. A receptacle 44 of FIG. 9 was located below the heating tube 40 for recovering copper molten from the composite 6. After the heat treatment, the heated core was introduced through the bottom of the treating bath E and then issued from the top thereof. During moving in the bath E, the core passed through molten Sn-Pb solder during which ultrasonic waves were applied to it with frequency 60 kHz and output 10W. After issuing from the bath, the core was cooled so that a superconductor wire coated with about 50 μm solder coating was produced. No breaking of the superconductor wire was noted. The core of the superconductor had a critical temperature of 91.0°C and critical current density of about 15000 A/cm$^2$ in liquid nitrogen.

Example 20

An oxide superconductor was produced in the same manner and conditions as in Example 12: the starting material powder mixture was calcined in ambient flowing oxygen of 1 liter/min; and the final heating was made also in ambient flowing oxygen of the same flow rate. This superconductor was equal in critical temperature and critical current density to the superconductor of Example 12.

Example 21

The starting material powder mixture was calcined, pulverized, pressed and heated in the same manner and conditions as in Example 1 except that the compact was heated at 890°C for 14 hours in an oxygen atmosphere. The intermediate sinter, thus obtained, was sheathed with a silver pipe having a 10 mm outer diameter and a thickness 1.5 mm and then subjected to rotary swaging to form a composite wire with a 1.0 mm diameter, which was placed in a 50 % nitric acid aqueous solution for removing the silver sheath to expose the core. The exposed core was heated at 890°C for 12 hours in an oxygen atmosphere and then gradually cooled to produce an superconducting core, which was then coated with about 10 to about 20 μm aluminum coating by placing it within an aluminum bath which was being vibrated with 20W 60kHz ultrasonic wave generator. Fifty superconducting core wires of this example were prepared and pulled to pass through the first and second separators, as in FIG. 14, which were rotated at a low speed for twisting, into an aluminum bath with an ultrasonic wave generator and then to issue from it for solidifying the molten aluminum adhered to the core wire to form a multifilamentary superconductor with an aluminum stabilizer, which exhibited a critical temperature (Tc) of 91K and a critical current density (Jc) of about 11,000 A/cm$^2$ at 77K.

Example 22

$BaCO_3$ and CuO powders, having a particle size about 3 μm, were mixed so that Ba:Cu=2:3 at mole ratio, the mixture was then calcined at 880°C for 10 hours in atmospheric air to produce a calcined powder, having a composition of $Ba_2Cu_3O_5$. The calcined powder was pulverized to a particle size about 10 μm and then mixed with both $Tl_2O_3$ and CaO powders, having a particle size about 3 μm to form a mixture so that Tl:Ca:Ba:Cu=2:2:2:3 at mole ratio. The starting material thus prepard was pressed to form a compact, with a green density 75% of the theoretical density, which was then heated at 870°C for 1 hour in ambient flowing oxygen 2 liters/min, followed by slow cooling at -200°C/hour to thereby produce an intermediate sinter having a composition $Tl_2Ca_2Ba_2Cu_3O_j$ (j undetermined) and a sintered density of about 85% of the theroretical density. The intermediate sinter was inserted into a silver pipe having an outer diameter 10 mm and a thickness 1.5 mm to form a preform, which was diameter reduced by a rotary swaging machine to a 0.5 mm diameter composite wire, which was then immersed in a dilute nitric acid to remove the silver sheath for exposing the core, which was in turn heated at 870°C for 30 minutes in ambient flowing oxygen gas of 2 liters/min to thereby produce a superconductor, having a composition $Tl_2Ca_2Ba_2Cu_3O_j$ (j undetermined) and a sintered density about 92% of the theoretical density, which had a critical temperature of 120K and critical current density of $2 \times 10^4$ $A/cm^2$ at 77K.

Example 23

Solutions of nitrates of Bi, Pb, Sr, Ca and Cu were mixed so that Bi:Pb:Sr:Ca:Cu=1.4:0.6:2:2:3 at mole ratio, and then ammonium oxalate was added to coprecipitate oxalates of the superconductor materials, which were dried to obtain a powder mixture with a particle size about 0.1µm, which was in turn calcined at 820°C for 12 hours in atmospheric air to produce a calcined powder. The calcined powder was charged into a silver pipe, having an outer diameter 10 mm and a thickness 1.5 mm, to form a preform, which was then diameter reduced by a rotary swaging machine to form a 1.5 mm diameter composite wire, having a 0.8 mm diameter core of a green density 85% of the theoretical density, which was then passed through high frequency induction coils to remove the silver sheath for exposing the core. Subsequently, the exposed core was heat treated at 850°C for 50 hours in atmospheric air to thereby produce a superconductor having a composition $Bi_2Pb_uSr_2Ca_2Cu_3O_v$ (u and v undetermined) and a sintered density of about 95% of the theoretical density, which was then coated with a 1 mm thick ceramics solder protection coating in a solder bath, containing a molten ceramics solder which includes lead, zinc, tin, aluminum, antimony, titanium, silicon, copper and cadmium, during application of 60 kHz ultrasonic waves at 10W output to the surface of superconductor. The coated superconductor had a critical temperature of 105K and critical current density of $1 \times 10^4$ $A/cm^2$ at 77K.

Example 24

An example of a manufacturing process for making the tape formed superconductive material will be described in detail in the following part.

As shown in Fig. 6, a steel pipe 204 made of a material selected from the group consisting of copper, silver, gold and platinum is prepared. Then, the pipe 204 is filled with base materials of a superconductive material or filled with a superconductive material, the materials being either powdery or solid state. According to Fig. 7, tubular space of the pipe 204 is filled with solid pellets made of superconductive material 205, and the pipe 204 and the superconductive material 205 forms a composite bar 206. Elemental composition of the superconductive material 205 is in a form of A-B-C-D as is mentioned above, and the base materials of that superconductive material comprise an oxide of the material A, a carbonic acid or an oxide of the material B, an oxide of the material C. The base material can be obtained also by heat treating a mixture of the base materials mentioned above and powdering it. Proportion of the base materials may be. determined according to the desired properties of the resultant superconductive material. Powdery superconductive material is obtained by heat treating the base materials obtained as mentioned above and powdering the superconductive solid material. Temperature of the heat treatment is between 400 and 900°C, and the solid material is powdered by the rubber press method.

Diameter of the composite bar 206 is then reduced by processing it by means of notched rollers or dies. During this process, the superconductive material 205 inside the pipe 204 is compressed. End portions of the pipe 204 should preferably be closed or made of an extensible material for an effective compaction of the superconductive material. This diametrical reduction can be performed by forging it using a rotary swaging machine A shown in Fig. 4. The rotary swaging machine A has a plurality of dies 10 which are located coaxial to the bar which is conveyed along its longitudinal axis. The dies 10 are supported so as to be movable in a plane perpendicular to the axis of the bar (direction B according to Fig. 4) and rotatable about the axis of the dies (direction C according to Fig. 4). Each of the dies has a tapered inner surface 12 of which the diameter decreases in the direction of conveyance of the bar. The bar is received by the inner surface 12 and as the bar proceeds, diameter of the bar is reduced being compressed by the tapered inner surface 12 of the die.

An end of the composite bar 206 is inserted in the opening of a die 10. While the bar 206 is proceeding, the die 10 is moving in the direction B and rotating in the direction C. As passing through the dies 10, diameter of the bar 206 is reduced to the diameter denoted by dotted lines in the figure. The rotary swaging machine permits to reduce the diameter of the bar at a large reduction ratio.

Then, the composite bar 206, of which the diameter is reduced by swaging, is rolled as shown in Fig. 4. Hot rolling is suitable because the method stabilizes the crystalline structure of the superconductive material. The rolling process can be performed many times so that the thickness of the material becomes the desired thickness. By virtue of the rolling process, thickness of the composite bar is reduced to a desired thickness and the bar is compressed to become in a tape form as shown in Fig. 6.

Then, the tape is heat treated in an oxygen atmosphere, at a temperature between 800 and 1000°C, for a few to hundreds of hours. The heat treatment also includes a cooling process which performed succeeding to the step mentioned above wherein the material is cooled at a rate of 50 to 500°C/hour. Atmosphere of the heat treatment can be a gaseous mixture containing a gas from the group IVb of the periodic table such as S or Se or a gas from the group VIIb of the periodic table such as F or Cl can be used to replace the oxygen gas.

Example 25

Superconductive tape can also be made by assembling superconductive wires, holding the wires by a metallic sheath, rolling the wires and the sheath, and heat treating it. The procedure will be described in more detail as follows.

First, a tube 303 made of a material such as silver, aluminum, copper, or an alloy of them having an inner electrically non-conductive layer 302 of $Ag_2O$, $Al_2O_3$, CuO etc. is prepared, as shown in Figure 9. Superconductive oxide, base materials for the superconductive oxide, whether in a powdery or in a solid form is put in the pipe 303. Fig. 9 shows a composite bar 305 made of the tube 303 and a solid superconductive material 304. The superconductive material and the base materials for the superconductive material are same as those described in previous examples. The solid superconductive material 304 is made by heat treating superconductive powders and pressing it in a pellet form by rubber pressing. Temperature of the heat treatment is preferably between 400 and 900°C.

Then, several composite bars 305 as above mentioned are assembled and inserted in a sheath 306 again made of silver, copper, etc. to make an assembly 307. The composite bars 305 may be wound together or arranged parallel to one another when they are inserted in the sheath 306. Diameter of the composite bars 305 may be reduced by a rolling process before being assembled to compress the pellets.

Then the assembly 307 is rolled by a conventional rolling procedure as shown in Fig. 11. Hot rolling method is preferable because it stabilizes the crystalline structure of the superconductive material 304 in the tube 303. Rolling process may be repeated so that the thickness of the sheath 306 becomes to a desired thickness, that is, between 10 and 10,000 um. By this rolling process, the assembly 307 becomes tape formed wherein the composite bars 305 are deformed to fill the space which existed between the bars 305, as shown in Fig. 12. Then, the assembly 307 in a tape form is heat treated to make a superconductive tape 310. Temperature of the heat treatment is preferably between 800 and 1,000°C. The material is cooled at a rate of 50 to 500°C/hour.

When powdery superconductive material is used to fill the tubes, the composite bars are preferably processed by HIP or CIP to compact the material before being assembled. In this case, temperature of the heat treatment after rolling the assembly is between 600 and 900°C so as to anneal the material. Diameter of the composite bar may be reduced before being assembled by means of a rotary swaging machine.

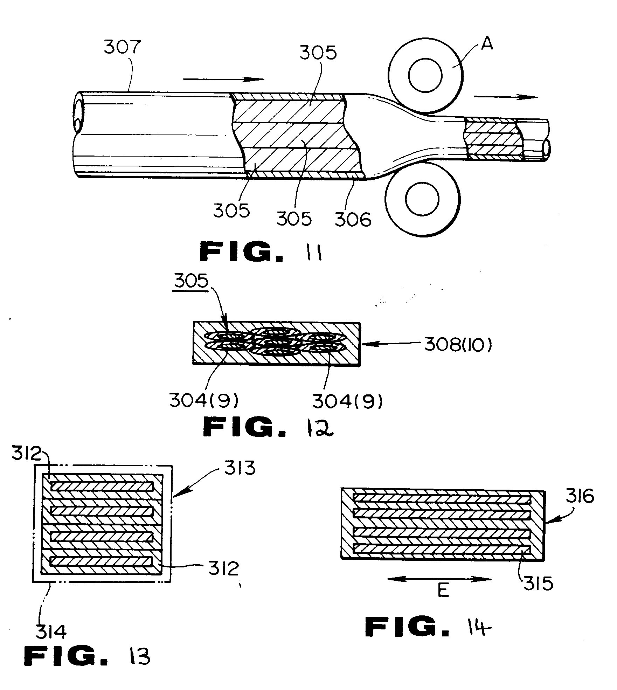

Thus obtained superconductive tapesc such as those shown in Figs. 12 through 14 may be assembled and covered by a covering material to make a tape assembly. This tape assembly is suitably used as superconductive cables or super-low-temperature cables.

**Claims**

1. A method for making a superconducting tape including a superconducting oxide represented by the formula

$$A_XB_YC_ZD_{7-d}$$

provided that the A is at least one element selected from the group consisting of Sc, Y, La, Ce, Pr, Nd, Pm, Sm, Eu, Gd, Dy, Tb, Ho, Er, Tm, Yb and Lu, the B is at least one element selection from the group consisting of Be, Sr, Mg, Ca, Ba and Ra, the C includes Cu, the D includes O, X being between about 0.1 and 2, Y being between about 1 and 3, Z being between about 1 and 3, d between about 0 and 5, the method comprising the steps of:

(a) pressing at least one material, being of a starting material powder of the superconducting oxide, a powder of the superconducting oxide, or a compact made of the starting material powder and/or the superconducting oxide powder, for forming a filling material;

(b) charging said filling material into a metallic pipe to form a preform;

(c) rotary swaging said preform to produce a compact having a density of not less than 75% of the theoretical density corresponding to zero porosity.

(d) roll pressing said compact to make a composite in a tape form having a metallic covering made of the metallic pipe and a core covered by the metallic covering; and

(e) heat treating the tape formed composite in an oxygen-containing atmosphere.

2. A method for making a superconducting tape including a superconducting oxide represented by the formula

$$A_X B_Y Ca_Z Cu_i O_j$$

provided that the A includes Bi or T1, the B includes Sr or Ba, X being between about 1 and 3, Y being between about 1 and 3, Z being between about 1 and 3, i between about 0 and 4, the method comprising the steps of:

(a) pressing at least one material, being of a starting material powder of the superconducting oxide, a powder of the superconducting oxide, or a compact made of the starting material powder and/or the superconducting oxide powder, for forming a filling material;

(b) charging said filling material into a metallic pipe to form a preform;

(c) rotary swaging said preform to produce a compact having a density of not less than 75% of the theoretical density corresponding to zero porosity;

(d) roll pressing said compact to make a composite in a tape form having a metallic covering made of the metallic pipe and a core covered by the metallic covering; and

(e) heat treating the tape formed composite in any oxygen-containing atmosphere.

3. A method for making a superconducting tape according to claim 1 or claim 2, wherein the material of the metallic pipe is selected from the group consisting of copper, silver, gold and platinum.

4. A method for making a superconducting tape according to claim 1, claim 2 or claim 3, wherein the filling material includes a superconducting material obtained by sintering the compact or by pulverising the sintered compact.

5. A method for making a superconducting tape according to claim 4 wherein the filling material is prepared by heat treating a mixture of the starting material powder and powdering them.

6. A method for making a superconducting tape according to any one of the preceding claims, wherein the temperature of the heat treatment is between 400 and 900°C, and the filling material is formed by the rubber press method.

7. A method for making a superconducting tape according to any one the preceding claims, wherein end portions of the pipe are closed.

8. A method for making a superconducting tape according to any one of the preceding claims, wherein the heat treatment is performed in an oxygenous atmosphere, at a temperature between 800 and 1000°C, for a few to hundreds of hours, and the heat treatment includes a cooling process of cooling the tape at a rate of 50 to 500°C/hour.

9. A method for making a superconducting tape according to any one of the preceding claims, wherein the atmosphere of the heat treatment is a mixture containing a gas from group IVb of the periodic table such as S or Se or a gas from group VIIb of the periodic table such as F or C1.

10. A method for making a superconducting tape according to any one of the preceding claims, which further comprises a step of assembling a plurality of the preforms, holding the preforms in a metallic sheath, and rolling the assembly comprising the preform and the sheath to make the assembly in a tape form.

**Patentansprüche**

1. Verfahren zur Herstellung eines supraleitenden Bandes umfassend ein supraleitendes Oxid der Formel

$$A_X B_Y C_Z D_{7-d}$$

mit der Maßgabe, daß A zumindest ein Element ist, das aus der Gruppe bestehend aus Sc, Y, La, Ce, Pr, Nd, Pm, Sm, Eu, Gd, Dy, Tb, Ho, Er, Tm, Yb und Lu ausgewählt ist, und B zumindest eine Elementauswahl aus der Gruppe bestehend aus Be, Sr, Mg, Ca, Ba und Ra ist, C Cu umfaßt, D O umfaßt, X zwischen etwa 0,1 und 2 ist, Y zwischen etwa 1 und 3 ist, Z zwischen etwa 1 und 3 ist, d zwischen etwa 0 und 5 ist, wobei das Verfahren folgende Schritte umfaßt:

(a) das Pressen von zumindest einem Material, das aus einem Ausgangsmaterialpulver des supraleitenden Oxids, einem Pulver des supraleitenden Oxids oder einem Preßling aus dem Ausgangsmaterialpulver und/oder dem supraleitenden Oxidpulver besteht, zum Bilden eines Füllmaterials;

(b) das Beschicken des genannten Füllmaterials in ein Metallrohr zum Bilden einer Vorform;

(c) das Drehgesenkschmieden bzw. -formen der genannten Vorform zur Herstellung eines Preßlings mit einer Dichte von nicht weniger als 75% der theoretischen der Null-Porosität entsprechenden Dichte;

(d) das Walzpressen des genannten Preßlings zur Herstellung eines Verbundkörpers in einer Bandform mit einer metallischen Abdeckung aus dem Metallrohr und einem Kern, der durch die Metallabdeckung bedeckt ist; und

(e) die Wärmebehandlung des bandförmigen Verbundkörpers in einer sauerstoffhältigen Atmosphäre.

2. Verfahren zur Herstellung eines supraleitenden Bandes einschließlich eines supraleitenden Oxids der Formel

$$A_x B_y Ca_z Cu_i O_j$$

mit der Maßgabe, daß A Bi oder Tl umfaßt, B Sr oder Ba umfaßt, X zwischen etwa 1 und 3, Y zwischen etwa 1 und 3, Z zwischen etwa 1 und 3 und i zwischen etwa 0 und 4 ist, wobei das Verfahren folgende Schritte umfaßt:

(a) das Pressen von zumindest einem Material, das aus einem Ausgangsmaterialpulver des supraleitenden Oxids, einem Pulver des supraleitenden Oxids oder einem Preßling aus dem Ausgangsmaterialpulver und/oder dem supraleitenden Oxidpulver besteht, zum Bilden eines Füllmaterials;

(b) das Beschicken des genannten Füllmaterials in ein Metallrohr zum Bilden einer Vorform;

(c) das Drehgesenkschmieden bzw. -formen der genannten Vorform zur Herstellung eines Preßlings mit einer Dichte von nicht weniger als 75% der theoretischen, der Null-Porosität entsprechenden Dichte;

(d) das Walzpressen des genannten Preßlings zur Herstellung eines Verbundkörpers in einer Bandform mit einer metallischen Abdeckung aus dem Metallrohr und einem Kern, der durch die Metallabdeckung bedeckt ist; und

(e) die Wärmebehandlung des bandförmigen Verbundkörpers in einer sauerstoffhältigen Atmosphäre.

3. Verfahren zur Herstellung eines supraleitenden Bandes nach Anspruch 1 oder Anspruch 2, worin das Material des Metallrohrs aus der Gruppe bestehend aus Kupfer, Silber, Gold und Platin ausgewählt wird.

4. Verfahren zur Herstellung eines supraleitenden Bandes nach Anspruch 1, Anspruch 2 oder Anspruch 3, worin das Füllmaterial ein supraleitendes Material umfaßt, das durch Sintern des Preßlings oder durch Pulverisieren des gesinterten Preßlings erhalten wird.

5. Verfahren zur Herstellung eines supraleitenden Bandes nach Anspruch 4, worin das Füllmaterial durch Wärmebehandlung eines Gemisches des Ausgangsmaterialpulvers und durch dessen Pulverisieren hergestellt wird.

6. Verfahren zur Herstellung eines supraleitenden Bandes nach einem der vorhergehenden Ansprüche, worin die Temperatur der Wärmebehandlung zwischen 400 und 900°C liegt und das Füllmaterial nach dem Gummipreßverfahren geformt wird.

7. Verfahren zur Herstellung eines supraleitenden Bandes nach einem der vorhergehenden Ansprüche, worin Endabschnitte des Rohrs geschlossen werden.

8. Verfahren zur Herstellung eines supraleitenden Bandes nach einem der vorhergehenden Ansprüche, worin die Wärmebehandlung in einer sauerstoffhältigen Atmosphäre bei einer Temperatur zwischen 800 und 1000°C über einige wenige bis hunderte Stunden erfolgt und die Wärmebehandlung ein Abkühlverfahren zum Abkühlen des Bandes mit einer Rate von 50 bis 500°C/Stunde umfaßt.

9. Verfahren zur Herstellung eines supraleitenden Bandes nach einem der vorhergehenden Ansprüche, worin die Atmosphäre bei der Wärmebehandlung ein Gemisch ist, das ein Gas aus der Gruppe IVb des Periodensystems, wie z.B. S oder Se, oder ein Gas aus der Gruppe VIIb des Periodensystems, wie z.B. F oder Cl, enthält.

10. Verfahren zur Herstellung eines supraleitenden Bandes nach einem der vorhergehenden Ansprüche, das weiters einen Schritt des Zusammenstellung einer Vielzahl der Vorformen, des Haltens der Vorformen in einer Metallhülle und des Walzens der Zusammenstellung umfassend die Vorform und die Hülle umfaßt, um die Zusammenstellung in einer Bandform herzustellen.

## Revendications

1. Méthode pour fabriquer une bande supraconductrice incluant un oxyde supraconducteur représenté par la formule

$$A_xB_yC_zD_{7-d}$$

à la condition que le A soit au moins un élément choisi dans le groupe consistant de Sc, Y, La, Ce, Pr, Nd, Pm, Sm, Eu, Gd, Dy, Tb, Ho, Er, Tm, Yb et Lu, le B est au moins un élément choisi dans le groupe consistant de Be, Sr, Mg, Ca, Ba et Ra, le C inclut Cu, le D inclut O, X étant entre environ 0,1 et 2, Y étant entre environ 1 et 3, Z étant entre environ 1 et 3, d entre environ 0 et 5, le procédé comprenant les étapes de :
   (a) pressage au moins un matériau, étant d'une poudre de matériau de départ de l'oxyde supraconducteur, une poudre de l'oxyde supraconducteur, ou un compact fait de la poudre de matériau de départ et/ou de la poudre d'oxyde supraconducteur, pour former un matériau de remplissage ;
   (b) chargement dudit matériau de remplissage dans un tuyau métallique pour former une préforme ;
   (c) emboutissage en rotation de ladite préforme pour produire un compact ayant une densité non inférieure à 75% de la densité théorique correspondant à une porosité 0 ;
   (d) pressage par rouleau dudit compact pour fabriquer un composite sous la forme d'une bande ayant une couverture métallique faite d'un tuyau métallique et d'un coeur couvert par la couverture métallique ; et
   (e) traitement thermique du composite formé en bande dans une atmosphère contenant de l'oyxgène.

2. Méthode pour fabriquer une bande supraconductrice incluant un oxyde supraconducteur représenté par la formule

$$A_xB_yCa_zCu_iO_j$$

à la condition que le A inclue Bi ou Tl, le B inclue Sr ou Ba, X étant entre environ 1 et 3, Y étant entre environ 1 et 3, Z étant entre environ 1 et 3, i entre environ 0 et 4, la méthode comprenant les étapes de :
   (a) pressage d'au moins un matériau, étant d'une poudre de matériau de départ de l'oxyde supraconducteur, une poudre de l'oxyde supraconducteur, ou un compact constitué de la poudre de matériau de départ et/ou la poudre de l'oxyde supraconducteur, pour former un matériau de remplissage ;
   (b) chargement dudit matériau de remplissage dans un tuyau métallique pour former une préforme ;
   (c) emboutissage en rotation de ladite préforme pour produire un compact ayant une densité non inférieure à 75% de la densité théorique correspondant à une porosité 0 ;
   (d) pressage par rouleau dudit compact pour fabriquer un composite sous la forme d'une bande ayant une couverture métallique faite d'un tuyau métallique et d'un coeur couvert par la couverture métallique ; et
   (e) traitement thermique du composé formé en bande dans toute atmosphère contenant de l'oxygène.

3. Méthode pour fabriquer une bande supraconductrice selon la revendication 1 ou 2, où le matériau du tuyau métallique est choisi parmi le groupe consistant du cuivre, de l'argent, de l'or et du platine.

4. Méthode pour fabriquer une bande supraconductrice selon la revendication 1, la revendication 2 ou la revendication 3, où le matériau de remplissage inclut un matériau supraconducteur obtenu par frittage du compact ou par pulvérisation du compact fritté.

5. Méthode pour fabriquer une bande supraconductrice selon la revendication 4, où le matériau de remplissage est préparé par traitement thermique d'un mélange de la poudre de matériau de départ et sa mise en poudre.

6. Méthode pour fabriquer une bande supraconductrice selon l'une quelconque des revendications précédentes, où la température du traitement thermique est entre 400 et 900°C, et le matériau de remplissage est formé par la méthode de presse à caoutchouc.

7. Méthode pour fabriquer une bande supraconductrice selon l'une quelconque des revendications précédentes, où les portions d'extrémité du tuyau sont fermées.

8. Méthode pour fabriquer une bande supraconductrice selon l'une quelconque des revendications précédentes, où le traitement thermique est effectué dans une atmosphère oxygénée, à une température entre 800 et 1000°C, pendant de quelques à des centaines d'heures, et le traitement thermique inclut un procédé de refroidissement de la bande à une vitesse de 50 à 500°C/heure.

9. Méthode pour fabriquer une bande supraconductrice selon l'une quelconque des revendications précédentes, où l'atmosphère du traitement thermique est un mélange contenant un gaz du groupe IVb du tableau périodique tel que S ou Se ou un gaz du groupe VIIb du tableau périodique tel que F ou Cl.

10. Méthode pour fabriquer une bande supraconductrice selon l'une quelconque des revendications précédentes, qui comprend de plus une étape d'assemblage d'une pluralité des préformes, le maintien des préformes dans un manchon protecteur métallique, et le roulement de l'assemblage comprenant la préforme et le manchon protecteur pour fabriquer l'assemblage sous une forme de bande.

**FIG.1**

**FIG.3**

**FIG.2**

FIG.4

FIG.5

201

202 203

**FIG.** 6

206

204

205

**FIG.** 7

206

205 204

D

**FIG.** 8

305

302
301 } 303

304

**FIG.** 9

307

306

305

305 305

**FIG.** 10

**FIG. 11**

**FIG. 12**

**FIG. 13**

**FIG. 14**